(19) Europäisches Patentamt
European Patent Office
Office européen des brevets

(11) **EP 4 299 245 A1**

(12) **EUROPEAN PATENT APPLICATION**

(43) Date of publication:
**03.01.2024 Bulletin 2024/01**

(21) Application number: **23178724.3**

(22) Date of filing: **12.06.2023**

(51) International Patent Classification (IPC):
**B24B 7/04** *(2006.01)* **B24B 7/24** *(2006.01)*

(52) Cooperative Patent Classification (CPC):
**B24B 7/04; B24B 7/241;** B24B 47/04

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **13.06.2022 JP 2022094880**

(71) Applicant: **Shin-Etsu Chemical Co., Ltd.
Tokyo (JP)**

(72) Inventors:
• **YARITA, Naoki**
**Joetsu-shi (JP)**
• **HARADA, Daijitsu**
**Joetsu-shi (JP)**
• **MATSUI, Harunobu**
**Joetsu-shi (JP)**
• **TAKEUCHI, Masaki**
**Joetsu-shi (JP)**

(74) Representative: **Mewburn Ellis LLP
Aurora Building
Counterslip
Bristol BS1 6BX (GB)**

(54) **SUBSTRATE AND METHOD FOR PRODUCING THE SAME**

(57)    Proposed herein is a method for producing a substrate suitable for mask blanks for EUVL and the method being capable of suppressing a concave defect having a depth of less than 5 nm.

The present invention provides a method for producing a substrate in which final polishing is performed by a polishing apparatus having an upper polishing plate equipped with a polishing pad, the method comprising the steps of placing a substrate stock in the polishing apparatus so that the main surface of the substrate stock face toward the upper polishing plate; rotating the upper polishing plate and polishing the substrate stock concomitantly with a polishing slurry on the main surface of the substrate stock; and raising the upper polishing plate which is kept being rotated to separate it from the main surface of the polished substrate stock.

**FIG.1**

EP 4 299 245 A1

**Description**

TECHNICAL FIELD

The present invention relates to a substrate and a method for producing the same, and more particularly to a glass substrate suitably used as a substrate for mask blanks and a method for producing the same.

BACKGROUND

As pattern miniaturization by photolithography progresses, quality requirements such as defect density, defect size, surface roughness, and flatness of a glass substrate used as a substrate for a photomask become more severe. In particular, with respect to defects on the substrate, even extremely minute defects which did not cause problems before may cause disorder of pattern formation, and improvement in sensitivity of the defect inspection machine enables detection of such minute defects, and it has been desired to reduce those disorders.

In recent years, an extreme ultraviolet lithography (hereinafter, abbreviated as "EUVL"), which is an exposure technique using extreme ultraviolet (hereinafter, abbreviated as "EUV") light, has attracted attention in order to realize formation of a finer pattern than conventional photolithography using ultraviolet rays. The EUV light is a light in a wavelength band of a soft X-ray region or a vacuum ultraviolet region having a wavelength of about 0.2 to 100 nm, and a reflective mask is practically used as a transfer mask used in EUVL. The surface quality required for the substrate for mask blanks used for such an EUVL reflective mask is particularly severe, and even a concave defect having a depth of less than 5 nm causes disturbance of pattern formation during exposure.

The surface quality of such a substrate for mask blanks is greatly affected by the method of performing the final stage (hereinafter, the polishing is referred to as final polishing) of the polishing step. For example, Patent Document 1 proposes a method in which a suede pad having a pad surface with a height difference of 50 $\mu$m or less between a maximum peak and a minimum peak on the surface is used, and a glass substrate is polished with a polishing load of 1 g/cm$^2$ to 60 g/cm$^2$ to suppress the occurrence of concave defects and obtain excellent surface smoothness.

In addition, Patent Document 2 proposes a method for producing a glass substrate for a mask blank in which when an area of a polishing cloth is $S_1$ (m$^2$), a surface area of a glass material is $S_2$ (m$^2$), and the number of the glass materials to be polished is N (sheets), a value Q represented by Q = N $\times$ $S_2$/$S_1$ is 0.05 or more and 0.2 or less, the polishing cloth has a substantially circular outer diameter D (m), and when a rotation speed of the polishing table with respect to the glass material is $\omega$ (rpm) and a supply amount of the polishing slurry is P(L/min), A represented by A = $(2\pi(D/2)2\omega)$/P is 1 or more and 15 or less, so that it is possible to significantly suppress variations in the number of concave defects.

On the other hand, Patent Document 3 discloses a method for producing a substrate in which a finish polishing step is performed by a both-side polishing apparatus which holds a substrate with a carrier while bringing two main surfaces of the substrate into contact with polishing pads of a rotating upper polishing plate and lower polishing plate, respectively. In the lower polishing plate of the both-side polishing apparatus, a solid formed by solidification of polishing abrasive grains or a foreign matter such as a processed piece generated when the substrate is polished tends to be retained on and inside the polishing pad. Therefore, the method is proposed in which the main surface of the substrate is polished on the upper polishing plate of the both-side polishing apparatus to suppress generation of new defects caused by the finish polishing step.

Citation List

> Patent Document 1: JP-A 2009 012164
> Patent Document 2: JP-A 2017-134108
> Patent Document 3: JP-A 2017-170588

SUMMARY OF THE INVENTION

However, as described in Patent Document 1, when a suede pad with a pad surface having a height difference of 50 $\mu$m or less between a maximum peak and a minimum peak on the surface is used and final polishing is performed with a polishing load of 1 g/cm$^2$ to 60 g/cm$^2$, it is possible to suppress the occurrence of a concave defect having a half-value width of 60 nm to 150 nm that can be detected even by a conventional surface defect inspection machine for a photomask, but it is insufficient to suppress the occurrence of a concave defect having a depth of less than 5 nm.

In addition, as described in Patent Document 2, by controlling the ratio of the surface area of the glass substrate to the area of the polishing cloth and the slurry flow rate, and as described in Patent Document 3, by performing finish polishing so that the main surface of the substrate is on the upper polishing plate of the both-side polishing apparatus, it is practically impossible to completely eliminate the presence of foreign matter which is in contact with the main surface of the substrate during polishing and can generate a concave defect having a depth of less than 5 nm, and thus it is difficult to say that these techniques are fundamental solutions.

The present invention has been made in view of the above circumstances, and an object of the present invention is to provide a method for producing a substrate, particularly a substrate suitable for mask blanks for EUVL in which occurrence of a concave defect having a depth of less than 5 nm is suppressed.

In order to solve the above problems, the inventors have conducted intensive studies focusing on the operation of the upper polishing plate at the end of processing when performing final stage polishing (hereinafter, abbreviated as "final polishing") in a finish polishing step of a substrate stock in a polishing apparatus including a polishing pad. As a result, the inventors have found that it was useful to place the substrate stock in the polishing apparatus such that the main surface of the substrate stock face toward the upper polishing plate, rotate the upper polishing plate and polish the substrate stock, and then separate the upper polishing plate from the main surface of the polished substrate stock without stopping the rotation of the upper polishing plate. By this method, the inventors have found that it is possible to reduce concave defects having a depth of less than 5 nm generated on the substrate surface as compared with a conventional processing method in which the polishing pad on the upper polishing plate is separated from the substrate surface after the rotation of the upper polishing plate is stopped, and then have achieved the present invention.

Accordingly, the present invention provides:

1. A method for producing a substrate in which final polishing is performed by a polishing apparatus having an upper polishing plate equipped with a polishing pad, the method comprising the steps of:

   placing a substrate stock in the polishing apparatus so that the main surface of the substrate stock face toward the upper polishing plate;
   rotating the upper polishing plate and polishing the substrate stock concomitantly with a polishing slurry on the main surface of the substrate stock; and
   raising the upper polishing plate which is kept being rotated to separate it from the main surface of the polished substrate stock,

2. The method of 1, wherein the upper polishing plate is separated from the main surface of the polished substrate stock at a rotation speed of 0.5 to 50 rpm,

3. The method of 1, wherein the upper polishing plate is separated from the main surface of the polished substrate stock at a raising speed of 0.1 to 50 mm/second,

4. The method of 1, wherein the polishing slurry has a viscosity of 0.5 to 30 mPa·s at 20°C,

5. The method of 1, wherein the polishing slurry contains 5 to 50% by weight of an abrasive grain component,

6. The method of 1, wherein the polishing slurry contains colloidal silica particles as an abrasive grain component,

7. The method of 6, wherein the colloidal silica particles have a mean primary particle size calculated from a specific surface measured by a gas adsorption method of 5 nm or more and 50 nm or less,

8. The method of 1, wherein the polishing slurry has pH of 8 to 11,

9. The method of 1, wherein the substrate is a glass substrate for use as a mask blank containing $SiO_2$ as a main component,

10. A glass substrate for use as a mask blank which is obtained by the method of 9,
wherein a maximum value of PSD_AVE $(\theta)$ of the substrate obtained by averaging the power spectral density PSD $(f, \theta)$ in the polar coordinate format in a range of a spatial frequency of 10 $\mu m^{-1}$ or more and 100 $\mu m^{-1}$ or less obtained by measuring a surface shape of a region of 1 $\mu m \times$ 1 $\mu m$ with an atomic force microscope is 0.05 $nm^4$ or less.

## ADVANTAGEOUS EFFECTS

According to the present invention, as compared with the conventional processing method in which the polishing pad on the upper polishing plate is separated from the substrate surface after the rotation of the upper polishing plate is stopped, it is possible to reduce the concave defects having a depth of less than 5 nm generated on the substrate surface, and it is possible to provide a substrate having high surface quality suitable as a substrate for mask blanks for EUVL.

## BRIEF DESCRIPTION OF THE DRAWINGS

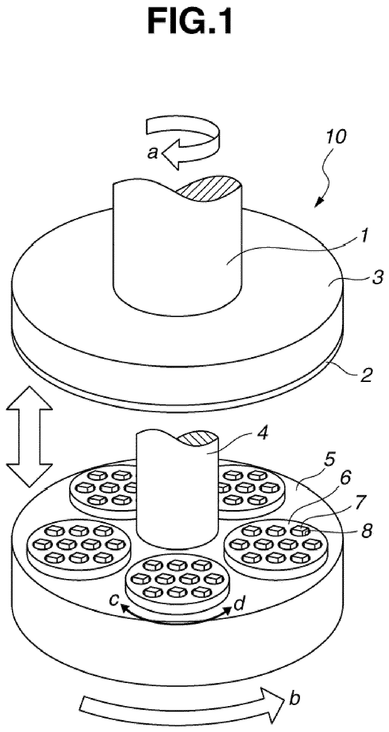

FIG. 1 is a schematic view of a both-side polishing apparatus used in an embodiment of a method for producing a substrate of the present invention.

FURTHER EXPLANATIONS; OPTIONS AND PREFERENCES

Hereinafter, the present invention will be described in detail.

Method for producing a substrate

A method for producing a substrate of the present invention includes, when performing final polishing by a polishing apparatus having an upper polishing plate equipped with a polishing pad, the steps of: placing a substrate stock in the polishing apparatus so that a main surface of the substrate stock face toward the upper polishing plate; rotating the upper polishing plate and polishing the substrate stock concomitantly with a polishing slurry on the main surface of the substrate stock; and raising the upper polishing plate which is kept being rotated to separate it from the main surface of the polished substrate stock. With this configuration, occurrence of a very shallow concave defect having a depth of less than 5 nm can be reduced.

Here, in the present invention, examples of the final polishing include a final polishing step during a finish polishing step for adjusting surface roughness of a starting substrate in which the scratches generated on the surface by the local polishing has been removed, the starting substrate is obtained by sequentially subjecting the substrate stock to a rough polishing step for roughly polishing a surface of a substrate stock obtained by molding, annealing, slicing, chamfering, and lapping a synthetic quartz glass ingot, a flatness measuring step for measuring flatness of a surface of a roughly polished substrate, and a local polishing step for local polishing.

(1) Polishing apparatus

The polishing apparatus used in the present invention is not particularly limited as long as it has an upper polishing plate provided with a polishing pad, and has a mechanism for polishing the substrate stock by bringing the upper polishing plate into contact with the main surface of the substrate stock, and then separating the polishing pad of the upper polishing plate from the main surface of the polished substrate stock. Examples of the polishing apparatus include a single-side polishing apparatus having an upper polishing plate provided with a polishing pad, and a both-side polishing apparatus having an upper polishing plate and a lower polishing plate each provided with a polishing pad. From the viewpoint of polishing efficiency, a both-side polishing apparatus is preferable.

Hereinafter, an embodiment of a method for producing a substrate of the present invention will be described below with reference to the accompanying drawing.

FIG. 1 illustrates a both-side polishing apparatus 10 used in a method for producing a substrate of an embodiment of the present invention. As illustrated in FIG. 1, in the polishing apparatus 10, an upper polishing plate 3 having a rotating shaft 1 and a polishing pad 2 on a lower surface is provided so as to be vertically movable, and a lower polishing plate 5 having a rotating shaft 4 and a polishing pad (not shown) on an upper surface is provided opposite to the upper polishing plate 3, and a plurality of carriers 6 are provided at equal intervals around the rotating shaft 4 of the lower polishing plate 5. A plurality of work holes 8 which hold substrate stocks (also referred to as works) 7 are formed in each carrier, and one substrate stock is held in each work hole. The carrier 6 is thinner than the substrate stocks, so that the substrate stocks 7 are polished as the upper polishing plate 3 moves downward to hold the substrate stocks between the upper polishing plate 3 and the lower polishing plate 5 and the upper polishing plate 3 is rotated in the direction of the wide arrow a (at a prescribed speed) around a rotating shaft 1 of the upper polishing plate 3 and the lower polishing plate 5 is rotated in the direction of the wide arrow b around the rotating shaft 4 of the lower polishing plate 5 and the carrier 6 is rotated in the direction of the arrow c or arrow d, with a polishing slurry (not shown) being supplied to the interface between the upper and lower polishing plates 3 and 5 and the substrate stocks 7. Note that, according to the above embodiment, the lower polishing plate are provided with more than one carriers but at least one carrier may be sufficient, and more than one work holes are also provided in this embodiment, but at least one work hole may be sufficient. The number of each of the plurality of carriers and work holes is not particularly limited, and can be appropriately selected according to the size of the polishing apparatus or the substrate stocks. The upper polishing plate 3 and the lower polishing plate 5 may also be rotated in opposite directions. Furthermore, the order of the rotation of the upper polishing plate, the contact of the upper polishing plate to the substrate stocks, and the polishing of the substrate stocks is not particularly limited, and for example, the upper polishing plate 3 may be first rotated and then brought into contact with the substrate stocks and polish at the same time, or the rotation of the upper polishing plate 3 and the contact with the substrate stocks may be simultaneously performed and then polish substrate stocks, or the upper polishing plate 3 may be first contact with the substrate stocks and then be rotated and polish the substrate stocks, and the order can be appropriately changed according to the polishing apparatus, the degree of polishing requirement, and the like.

In such a polishing mechanism, a resultant force composed of vertical component due to a load from the upper polishing plate and horizontal component due to the rotation of the upper polishing plate and the carriers is applied to the main surfaces of the substrate stocks being polished. When the rotation of the upper polishing plate is completely stopped in a state where the polishing pad on the upper polishing plate is in contact with the main surfaces of the substrate stocks at the end of polishing, the combined vector of the forces applied to the main surface of the substrate stocks is biased from the horizontal direction to the vertical direction with respect to the substrate stocks as the rotation speed of the upper polishing plate is decelerated. At this time, when there is any foreign matter between the main surfaces of the substrate stocks and the polishing pad on the upper polishing plate which can grind the substrate surfaces with higher efficiency than the abrasive grains in the polishing slurry, the vertical component of the impulse applied from the foreign matter to the main surfaces of the substrate stocks concentrates in limited regions in the main surfaces of the substrate stocks, and as a result, local concave structures remain on the main surfaces of the substrate stocks.

On the other hand, according to the producing method of the present invention, the polishing pad on the upper polishing plate is separated from the main surfaces of the substrate stocks while the upper polishing plate is rotated at the end of polishing. In this case, even if there are some foreign matters between the main surfaces of the substrate stocks and the polishing pad on the upper polishing plate which can grind the substrate surfaces with higher efficiency than the abrasive grains, the component in the vertical direction of the impulse applied from the foreign matter to the main surfaces of the substrate stocks is not concentrated in limited regions in the main surfaces of the substrate stocks, so that it is difficult to leave a local concave structure in the main surfaces of the substrate stocks, and as a result, concave defects can be reduced.

The rotation speed of the upper polishing plate when the upper polishing plate is separated from the main surface of the substrate stock is not particularly limited, but it is preferably 0.5 rpm to 50 rpm, more preferably 1 rpm to 30 rpm, and still more preferably 5 rpm to 20 rpm from the viewpoint of the tendency of scratching the substrate stocks. The rotation direction of the upper polishing plate is not particularly limited, but in the case of using a both-side polishing apparatus, the rotation direction is preferably opposite to the rotation direction of the lower polishing plate.

The rising speed of the upper polishing plate when the polishing pad on the upper polishing plate and the main surface of the substrate stock are separated from each other at the end of polishing is preferably 0.1 mm/second to 50 mm/second, more preferably 0.5 mm/second to 20 mm/second, and still more preferably 1 mm/second to 10 mm/second, considering that if the rising speed is too slow, the polishing slurry evaporates on the main surface of the substrate stock and causes convex defects, whereas if the rising speed is too fast, the substrate tends to adhere to the polishing pad on the upper polishing plate.

As other polishing conditions such as the rotation speed of the upper polishing plate and the lower polishing plate before the upper polishing plate is lifted, that is, during polishing, and the polishing pressure, normal conditions can be adopted.

(2) Polishing slurry

The viscosity of the polishing slurry used in the present invention is preferably 0.5 mPa s to 30 mPa s, more preferably 0.5 mPa s to 10 mPa s, and still more preferably 1 mPa s to 5 mPa s at 20°C considering that the abrasive grains in the polishing slurry are more between the main surface of the substrate stock and the polishing pad on the upper polishing plate, and are uniformly spread to easily obtain the effect of dispersing the component in the vertical direction of the impulse received by the main surface of the substrate stock from the foreign matter. The above viscosity of the polishing slurry can be measured using a commercially available viscometer, for example, a viscometer Model TVC-7, made by Toki Sangyo Co., Ltd.

The concentration of the abrasive grain component in the polishing slurry is preferably 5% by weight or more, more preferably 10% by weight or more, and still more preferably 20% by weight or more considering that the abrasive grains in the polishing slurry are more present between the main surface of the substrate stock and the polishing pad on the upper polishing plate to easily obtain the effect of dispersing the component in the vertical direction of the impulse that the main surface of the substrate stock receives from the foreign matter. On the other hand, the content is preferably 50% by weight or less, more preferably 45% by weight or less, and still more preferably 40% by weight or less in consideration of suppressing occurrence of concave defects due to the tendency of the abrasive grains to aggregate easily.

As the abrasive grain component contained in the polishing slurry, colloidal silica particles are preferable, and colloidal silica in which the colloidal silica particles are dispersed in water can be used as a raw material of the polishing slurry. As the colloidal silica, a commercially available product can be used, and examples of the commercially available colloidal silica include GP series, PL series, and BS series made by FUSO CHEMICAL CO., LTD.

A method for synthesizing the colloidal silica particles is not particularly limited, but from the viewpoint of reducing metal contamination, a high-purity colloidal silica particles produced by hydrolyzing an organic silicate compound such as alkoxysilane is preferable.

The mean primary particle size of the colloidal silica particles is preferably 5 nm or more, more preferably 10 nm or more, and preferably 50 nm or less, more preferably 30 nm or less from the viewpoint of ease of removal of the colloidal silica particles in the polishing slurry remaining on the substrate surfaces after polishing, the viewpoint of achieving both reduction of surface roughness and concave defects, and polishing efficiency. The mean primary particle size of the colloidal silica particles can be calculated from a specific surface area (for example, the BET specific surface area) measured by a gas adsorption method. In this case, the specific surface area can be measured using colloidal silica before being formed into a polishing slurry, with colloidal silica particles in a dry state.

The pH of the polishing slurry is preferably 8 or more, more preferably 8.5 or more for obtaining sufficient dispersion stability of the colloidal silica particles. On the other hand, the pH of the polishing slurry is preferably 11 or less, and more preferably 10.5 or less from the viewpoint of suppressing the etching amount of the substrate stock during polishing and suppressing the occurrence of concave defects.

(3) Polishing pad

The polishing pad used in the producing method of the present invention is not particularly limited, but a soft suede pad is preferable from the viewpoint of emphasizing the surface quality of the substrate stock.

(4) Substrate stock to be polished

According to the producing method of the present invention, the size and thickness of the substrate stock to be polished are not particularly limited, but in the case of a substrate stock for a photomask blank, a 6-inch square substrate used in a normal substrate for a photomask blank is preferable in consideration of being used in a current EUVL exposure apparatus, and for example, a 6025 substrate having a square shape of 152 mm $\times$ 152 mm $\times$ 6.35 mm, and the like can be included. Examples of the substrate having a circular shape include those having a diameter of 6 inches, 8 inches, and 12 inches.

In a case where the thickness of the substrate stock is less than 5 mm, the substrate stock tend to be easily attached to the polishing pad on the upper polishing plate when the upper polishing plate is lifted at the end of polishing, and it may be difficult to separate the main surface of the substrate stock from the polishing pad on the upper polishing plate in a state where the upper polishing plate is rotated. On the other hand, when the thickness of the substrate stock is 5 mm or more, the substrate stock remains on the polishing pad on the lower polishing plate by its own weight, which is preferable for applying the producing method of the present invention. The upper limit of the thickness of the substrate stock is not particularly limited, but is preferably 10 mm or less, and more preferably 8 mm or less.

A material of the substrate applied to the producing method of the present invention is not particularly limited, but a glass substrate containing $SiO_2$ as a main component is preferable because it is necessary to use a substrate with a small thermal expansion coefficient when the substrate is used in an exposure process in EUVL. The glass substrate containing $SiO_2$ as a main component is not particularly limited, and examples thereof include a titania-doped synthetic quartz glass substrate obtained by doping synthetic quartz glass with titania at a ratio of 5% by weight to 10% by weight. In addition, the producing method of the present invention may also be applied to production of substrates from soda lime glass, silicon wafer, sapphire, gallium nitride, lithium tantalate, etc. by the same steps as mentioned above. A glass substrate containing $SiO_2$ as a main component, particularly a titania doped synthetic quartz glass substrate can be suitably used as a glass substrate for mask blanks.

(5) Production steps

As described above, the producing method of the present invention is applied to, for example, a finish polishing step for adjusting surface roughness of a starting substrate in which the scratches generated on the surface by the local polishing has been removed, the starting substrate is obtained by sequentially subjecting the substrate stock to a rough polishing step for roughly polishing a surface of a substrate stock obtained by molding, annealing, slicing, chamfering, and lapping a synthetic quartz glass ingot, a flatness measuring step for measuring flatness of a surface of a roughly polished substrate, and a local polishing step for local polishing. However, in a case where a flaw of the substrate stock is not completely removed in a single finish polishing step by the local polishing step, a preliminary polishing step for mirror finishing the surface of the substrate may be performed between the local polishing step and the final polishing of the present invention to obtain higher surface quality, and a multi-stage finish polishing step may be performed. As the synthetic quartz glass ingot, a synthetic quartz glass ingot having a composition corresponding to the substrate to be produced may be used. For example, in a case of producing a titania-doped synthetic quartz glass substrate, a synthetic quartz glass ingot doped with titania at a predetermined concentration can be used.

The rough polishing step can be performed using a polishing agent containing, for example, cerium oxide particles, zirconium oxide particles, colloidal silica particles, etc. as abrasive grains in a both-side polishing machine of planetary motion or the like.

After the rough polishing step, the flatness of the substrate surface is measured in the flatness measuring step. In order to reduce the processing time of the subsequent local polishing step, the flatness (TIR) of the region of 142 mm × 142 mm is preferably in the range of 100 nm to 1000 nm at the time after the rough polishing step is completed. The flatness can be measured using a commercially available flat tester for a photomask, for example, UltraFlat made by Tropel Corporation.

The method of the local polishing step is not particularly limited as long as the amount of polishing at each site on the substrate surface can be determined on the basis of measurement data of the substrate surface measured in advance, and the polishing amount at each site on the substrate surface can be controlled. For example, the method can be selected from a partial polishing method using a small rotary processing tool, a Magneto Rheological Finishing (MRF) method using a magnetic fluid containing a polishing agent, a method using a gas clutter ion beam (GCIB), plasma etching, etc. In a partial polishing method using a small rotary processing tool, a polishing amount is controlled by a speed of moving the tool. In other words, in a case where it is desired to increase the polishing amount, the speed at which the tool passes through the substrate surface is reduced. In a case where the substrate is almost in a target shape and the polishing amount may be small, the speed at which the tool passes through the substrate surface is increased to control the amount of polishing.

The processing part of the small rotary processing tool is not particularly limited, but it is preferable to adopt a part using a Leutor-type rotary processing tool.

Here, from the viewpoint of reducing the polishing damage to the glass and the like, the material of the rotary processing tool in contact with the glass can be selected from polyurethane having a hardness A50 to A75 (according to JISK6253), a felt buff, rubber, a cerium pad, and the like, but is not limited to these types as long as the glass surface can be ground.

In addition, the shape of the polished portion of the rotary working tool is not particularly limited, and examples thereof include a circle or donut shape, a cylindrical shape, a cannonball-like shape, a disk shape, and a barrel shape.

The flatness (TIR) of an arbitrary region of 142 mm × 142 mm on the substrate surface after the local polishing step is preferably 100 nm or less, and more preferably 50 nm or less. In addition, the shape can be arbitrarily selected according to the specifications such as a convex shape and a concave shape according to the conditions of the finish polishing in the subsequent stage.

After the local polishing step, the final polishing of the present invention is performed in the finish polishing step, whereby a polished substrate can be obtained.

Polished substrate

In the substrate obtained according to the present invention, the maximum value of PSD_AVE ($\theta$) obtained by averaging a power spectral density PSD (f, $\theta$) in a polar coordinate format in a range of a spatial frequency of 10 $\mu$m$^{-1}$ or more and 100 $\mu$m$^{-1}$ or less obtained by measuring a surface shape of an arbitrary region of 1 $\mu$m × 1 $\mu$m with an atomic force microscope can be preferably 0.05 nm$^4$ or less by applying the above-described method for producing the substrate of the present invention. Such a substrate has reduced concave defects having a depth of less than 5 nm, and is suitable as a substrate for mask blanks for EUVL.

Here, the atomic force microscope can be appropriately selected from conventionally known ones, and specific examples thereof include Cypher ES made by Oxford Instruments PLC.

The angular power spectral density is calculated from the discrete Fourier transform F (u, v) of the surface shape Z (Px, Py) of the glass substrate. F (u, v) is calculated by the following mathematical formula (1).

$$F(u,v) = \sum_{p_x=0}^{N_x-1} \sum_{p_y=0}^{N_y-1} Z(p_x, p_y) exp\left[-i2\pi\left(\frac{up_x}{N_x} + \frac{vp_y}{N_y}\right)\right] \cdots (1)$$

Here, Nx and Ny are the number of measurement points in the x and y directions at the time of measuring the surface shape of the glass substrate. Px and Py are integers indicating the positions of the measurement points in the x and y directions, and have values of Px = 0, 1, ... , and Nx-1 and Py = 0, 1, ... , and Ny-1. On the other hand, u and v take values of u = - 1/2, -1/2+1/Nx, ... , 1/2, and v = -1/2, -1/2+1/Ny, ... , 1/2.

By normalizing F (u, v) with the measurement pitches $\Delta$x and $\Delta$y in the x and y directions and the area A of the measurement region = (Nx$\Delta$x) × (Ny$\Delta$y) as in the following mathematical formula (2), the power spectral density P (u, v) can be obtained.

$$P(u, v) = \frac{1}{A} |F(u,v)\Delta x \Delta y|^2 = \frac{A}{\left(N_x N_y\right)^2} |F(u,v)|^2 \cdots (2)$$

Without this normalization, the power spectral densities calculated from the conditions of different measurement regions and measurement pitches cannot be simply compared.

On the other hand, the spatial frequency f (u, v) and the angle θ are expressed by the following mathematical formulas (3) and (4), respectively.

$$f = \sqrt{\left(\frac{u}{\Delta x}\right)^2 + \left(\frac{v}{\Delta y}\right)^2} \cdots (3)$$

$$\theta = \text{sgn}\left(\frac{v}{\Delta y}\right)\arccos\left(\frac{u}{\Delta x} \Big/ \sqrt{\left(\frac{u}{\Delta x}\right)^2 + \left(\frac{v}{\Delta y}\right)^2}\right) \cdots (4)$$

The PSD (f, θ) in the polar coordinate format is obtained by coordinate-transforming P (u, v) by mathematical formulas (3) and (4).

Further, PSD_AVE (θ) obtained by averaging a PSD (f, θ) in a polar coordinate format in a range where the spatial frequency f is 10 $\mu$m$^{-1}$ or more and 100 $\mu$m$^{-1}$ or less is expressed by the following mathematical formula (5).

$$\text{PSD\_AVE}(\theta) = \sum_{10\mu m^{-1} \leqq f \leqq 100\mu m^{-1}} \frac{1}{N_f} PSD(f, \theta) \cdots (5)$$

Here, Nf is the number of measurement points satisfying the following mathematical formula (6).

$$10\mu m^{-1} \leqq f \leqq 100\mu m^{-1} \cdots (6)$$

The maximum value of PSD _AVE (θ) is preferably 0.05 nm$^4$ or less, and more preferably 0.04 nm$^4$ or less, from the viewpoint of avoiding that when cleaning is performed before film formation is performed on the main surface of the polished substrate, etching of the main surface of the substrate proceeds, and a concave structure is amplified to form a concave defect that can be detected by a defect inspection apparatus.

EXAMPLES

Hereinafter, the present invention will be specifically described with reference to Examples and Comparative Examples, but the present invention is not limited to the following Examples.

Examples 1 to 4

The sliced titania doped synthetic quartz glass starting substrates (6 inch square, 6.35 mm thick) were lapped with a both-side lapping machine of planetary motion, and then roughly polished with a both-side polishing machine of planetary motion. The flatness of the surface of the roughly polished substrate was measured, local polishing was performed using a small rotary processing tool, and then preliminary finish polishing was performed using a polishing agent containing colloidal silica particles as abrasive grains by a both-side polishing machine of planetary motion to prepare substrate stocks.

The substrate stocks subjected to preliminary finish polishing were subjected to final polishing using a both-side polishing apparatus in which a suede polishing cloth was attached to the upper polishing plate and the lower polishing plate. In the final polishing step, a polishing slurry containing 25% by weight of colloidal silica particles having a mean primary particle size of 16 nm as an abrasive grain component and having a pH adjusted to 9.4 was used.

Ten substrate stocks 7 were placed in the work holes 8 formed in the carriers 6 of the lower polishing plate 5 of the polishing apparatus 10 illustrated in FIG. 1 such that the main surfaces were directed to the upper polishing plate, polishing was performed by appropriately adjusting the load and the rotation speeds of the upper polishing plate 3 and the lower polishing plate 5 such that the polishing allowance of the main surfaces was 100 nm in a polishing time of 30 minutes, and then the upper polishing plate 3 was raised while being rotated without stopping the rotation of the upper polishing plate 3, and the polishing pad 2 on the upper polishing plate 3 was separated from the main surfaces of the polished substrates. The rotation speed and the rising speed of the upper polishing plate 3 and the viscosity of the polishing slurry when the polishing pad 2 on the upper polishing plate 3 is separated from the main surfaces of the polished substrates are shown in Table 1 below.

The polished substrates were cleaned and dried, and then a defect inspection of the main surfaces of the substrates was performed using a defect inspection apparatus for a substrate for a mask blank (made by Lasertec Corporation), and a defect occurrence site was observed with an atomic force microscope to measure the number of concave defects having a depth of less than 5 nm. The ten polished substrates were observed to determine the average number of defects per a substrate stock.

In addition, the surface shape of a region of $1\ \mu\text{m} \times 1\ \mu\text{m}$ in the main surface of the substrate was measured with an atomic force microscope to calculate the maximum value of PSD_AVE ($\theta$) obtained by averaging a power spectral density PSD (f, $\theta$) in a polar coordinate format in a range of a spatial frequency of $10\ \mu\text{m}^{-1}$ or more and $100\ \mu\text{m}^{-1}$ or less. The ten polished substrates were measured, and the average of the maximum values of the respective substrates was calculated. The results are also shown in Table 1.

Table 1

| Example | Rotation speed of upper polishing plate (rpm) | Rising speed of upper polishing plate (mm/second) | Viscosity of polishing slurry (mPa·s) | Number of concave defects with a depth of less than 5 nm per substrate (number) | Maximum value of PSD_AVE ($\theta$) (nm4) |
|---|---|---|---|---|---|
| 1 | 0.5 | 0.5 | 12 | 1.5 | 0.05 |
| 2 | 10 | 0.5 | 12 | 0.8 | 0.04 |
| 3 | 10 | 5 | 12 | 0.6 | 0.04 |
| 4 | 10 | 5 | 2 | 0.3 | 0.02 |

Comparative Examples 1 to 3

The final polishing of the substrates were performed and evaluated in the same manner as in Examples 1 to 4 except that after the polishing was performed, the rotation of the upper polishing plate was stopped, the upper polishing plate was raised in a state where the rotation of the upper polishing plate was stopped, and the polishing pad on the upper polishing plate was separated from the main surfaces of the polished substrate stocks. The results are shown in Table 2.

Table 2

| Comparative Example | Rotation speed of upper polishing plate (rpm) | Rising speed of upper polishing plate (mm/second) | Viscosity of polishing slurry (mPa·s) | Number of concave defects with a depth of less than 5 nm per substrate (number) | Maximum value of PSD_AVE ($\theta$) (nm4) |
|---|---|---|---|---|---|
| 1 | 0 | 0.5 | 12 | 5.1 | 0.08 |
| 2 | 0 | 5 | 12 | 4.5 | 0.08 |
| 3 | 0 | 5 | 2 | 3.2 | 0.06 |

Japanese Patent Application No. 2022-094880 is incorporated herein by reference.

Although some preferred embodiments have been described, many modifications and variations may be made thereto in light of the above teachings. It is therefore to be understood that the invention may be practiced otherwise than as specifically described without departing from the scope of the appended claims.

**Claims**

1. A method for producing a substrate in which final polishing is performed by a polishing apparatus having an upper polishing plate equipped with a polishing pad, the method comprising the steps of:

   placing a substrate stock in the polishing apparatus so that the main surface of the substrate stock face toward the upper polishing plate;
   rotating the upper polishing plate and polishing the substrate stock concomitantly with a polishing slurry on the main surface of the substrate stock; and
   raising the upper polishing plate which is kept being rotated to separate it from the main surface of the polished substrate stock.

2. The method of claim 1, wherein the upper polishing plate is separated from the main surface of the polished substrate stock at a rotation speed of 0.5 to 50 rpm.

3. The method of claim 1 or 2, wherein the upper polishing plate is separated from the main surface of the polished substrate stock at a raising speed of 0.1 to 50 mm/second.

4. The method of any one of claims 1 to 3, wherein the polishing slurry has a viscosity of 0.5 to 30 mPa·s at 20°C.

5. The method of any one of claims 1 to 4, wherein the polishing slurry contains 5 to 50% by weight of an abrasive grain component.

6. The method of any one of claims 1 to 5, wherein the polishing slurry contains colloidal silica particles as an abrasive grain component.

7. The method of claim 6, wherein the colloidal silica particles have a mean primary particle size calculated from a specific surface measured by a gas adsorption method of 5 nm or more and 50 nm or less.

8. The method of any one of claims 1 to 7, wherein the polishing slurry has pH of 8 to 11.

9. The method of any one of claims 1 to 8, wherein the substrate is a glass substrate for use as a mask blank containing $SiO_2$ as a main component.

10. A glass substrate for use as a mask blank which is obtained by the method of claim 9,
    wherein a maximum value of PSD_AVE ($\theta$) of the substrate obtained by averaging the power spectral density PSD (f, $\theta$) in the polar coordinate format in a range of a spatial frequency of 10 $\mu$m$^{-1}$ or more and 100 $\mu$m$^{-1}$ or less obtained by measuring a surface shape of a region of 1 $\mu$m $\times$ 1 $\mu$m with an atomic force microscope is 0.05 nm$^4$ or less.

# FIG.1

Europäisches
Patentamt

European
Patent Office

Office européen
des brevets

# EUROPEAN SEARCH REPORT

**Application Number**

EP 23 17 8724

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 3 923 071 A1 (SHINETSU CHEMICAL CO [JP]) 15 December 2021 (2021-12-15) | 10 | INV.<br>B24B7/04 |
| A | * paragraph [0018] * | 2-9 | B24B7/24 |
| A | EP 3 093 105 A1 (SHINETSU CHEMICAL CO [JP]) 16 November 2016 (2016-11-16)<br>* paragraph [0019]; figure 1 * | 1-10 | |

**TECHNICAL FIELDS SEARCHED (IPC)**

B24B

The present search report has been drawn up for all claims

| Place of search | Date of completion of the search | Examiner |
|---|---|---|
| Munich | 20 November 2023 | Koller, Stefan |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

........................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 17 8724

This annex lists the patent family members relating to the patent documents cited in the above-mentioned European search report.
The members are as contained in the European Patent Office EDP file on
The European Patent Office is in no way liable for these particulars which are merely given for the purpose of information.

20-11-2023

| Patent document cited in search report | | Publication date | Patent family member(s) | | Publication date |
|---|---|---|---|---|---|
| EP 3923071 | A1 | 15-12-2021 | CN | 113777875 A | 10-12-2021 |
| | | | EP | 3923071 A1 | 15-12-2021 |
| | | | JP | 7268644 B2 | 08-05-2023 |
| | | | JP | 2021193436 A | 23-12-2021 |
| | | | JP | 2023095868 A | 06-07-2023 |
| | | | KR | 20210152951 A | 16-12-2021 |
| | | | TW | 202212278 A | 01-04-2022 |
| | | | US | 2021382386 A1 | 09-12-2021 |
| EP 3093105 | A1 | 16-11-2016 | CN | 106141918 A | 23-11-2016 |
| | | | EP | 3093105 A1 | 16-11-2016 |
| | | | KR | 20160134506 A | 23-11-2016 |
| | | | MY | 186276 A | 02-07-2021 |
| | | | US | 2016332280 A1 | 17-11-2016 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2009012164 A
- JP 2017134108 A
- JP 2017170588 A
- JP 2022094880 A